# EUROPÄISCHE PATENTSCHRIFT

(11) **EP 0 707 383 B1**
(45) Veröffentlichungstag und Bekanntmachung des Hinweises auf die Patenterteilung: **02.05.2002**
(21) Anmeldenummer: 95250144.3
(22) Anmeldetag: 14.06.1995
(51) Int. Cl.: H03M 1/00, H03M 1/12, H03M 1/18

(54) **Schaltungsanordnung zur Analog-Digital-Wandlung von Signalen**
Circuit for analogue-digital conversion of signals
Circuit pour conversion de signaux d'anlogiques numériques

(30) Priorität: 14.06.1994 DE 4420713
(43) Veröffentlichungstag der Anmeldung: 17.04.1996
(60) Teilanmeldung: 01109089.1
(73) Patentinhaber: Stage Tec Entwicklungsgesellschaft für professionelle Audiotechnik mbH, 12459 Berlin (DE)
(72) Erfinder: Knoth, Matthias, D-63584 Gründau (DE); Reussner, Thomas, D-64289 Darmstadt (DE)
(74) Vertreter: Burghardt, Dieter, Dipl.-Ing.

(56) Entgegenhaltungen:
- EP-A- 0 346 605
- WO-A-87/06080
- US-A- 4 129 864
- US-A- 4 999 628

## Beschreibung

Die Erfindung bezieht sich auf eine Schaltungsanordnung zur hochauflösenden Umwandlung eines analogen Audiosignals in einen digitalen Datenstrom, wobei das Anwendungsgebiet der Erfindung in der Sensortechnik, der Meßtechnik, der Audiotechnik und auch im weiten Bereich der applikationsspezifischen Mikroprozessoranwendung liegt.

Es ist bekannt, daß Analogsignale mit einer großen Dynamik, also solche mit kleinen und großen Werten, insbesondere hinsichtlich der kleinen Werte nur ungenau zu digitalisieren sind. Dies führt zu größeren Rechenfehlern bei weiterer digitaler Verarbeitung bzw. zu einem Ansteigen des Klirrfaktors bei kleiner werdenden Signalen. Aus diesem Grund finden in den oben genannten Fällen AD-Wandler mit einer hohen Auflösung Anwendung, obwohl die damit erzielbare genauere Digitalisierung großer Werte oftmals nicht benötigt wird und zudem hochauflösende AD-Wandler erheblich teurer sind. Einigen Anwendungen blieb die digitale Verarbeitung bisher ganz verschlossen, da derartig hochauflösende Wandler bei entsprechender Wandlungsrate bislang nicht verfügbar waren. Stellvertretend sei hier das Studiomikrofon für den professionellen Einsatz mit integriertem AD-Wandler genannt.

In allen diesen Bereichen versucht man seit langem kostengünstige, weniger hochauflösende Wandler mit schaltbarer Vorverstärkung auszustatten.

In der DE-OS 43 12 697 wird das Problem eines hochauflösenden AD-Wandlers mit zwei weniger hochauflösenden AD-Wandlern und einem hochauflösenden DA-Wandler gelöst.

In der DE-OS 36 03 833 wird ein steuerbarer Verstärker (VCA) verwendet, um einen weniger hochauflösenden AD-Wandler stets im optimalen Arbeitsbereich zu halten. Mit einem zweiten, weniger hochauflösenden AD-Wandler wird die Steuerspannung des VCA digitalisiert und einem Exponenten entsprechend mit dem Digitalsignal des ersten AD-Wandlers verknüpft.

Ein prinzipiell anderer Weg wird mit der DE-OS 29 46 502 gegangen. Hier wird ein hochauflösender AD-Wandler für seismische Signale beschrieben, der mit einem weniger hochauflösenden AD-Wandler und mit mehreren Vorverstärkern mit fester und bekannter Vorverstärkung aufgebaut ist. Je nach Größe des zu digitalisierenden Signals wird der AD-Wandler mit dem geeigneten Vorverstärker verbunden, und das Digitalsignal durch Division mit dem Vorverstärkungsfaktor gewonnen. Das gleiche Verfahren beschreibt auch die DE-OS 38 16 903.

Mit der Lehre nach der DE-OS 36 11 922 wird diese Idee weiterentwickelt. Es wird ein hochauflösender AD-Wandler beschrieben, der aus zwei weniger hochauflösenden AD-Wandlern besteht, wobei einer mit einem Vorverstärker betrieben wird. Das Digitalsignal dieses AD-Wandlers wird anschließend durch den Vorverstärkungsfaktor dividiert.

In der DE-OS 38 20 144 werden hochauflösende AD- und DA-Wandler für die Audiotechnik beschrieben mit dem Ziel einen 20 bit AD-Wandler aus 16 bit AD-Wandlern aufzubauen.

Für Mikrofonverstärker, die sowohl für dynamische- als auch für Kondensatormikrofone geeignet sind, sind sogar 27..28 bit AD-Wandler erforderlich, falls nicht eine Einstellung der Vorverstärkung erfolgt.

In der EP-A 0 346 605 werden verschiedene Anordnungen offenbart, die immer darauf beruhen, daß das Eingangssignal parallel verschiedene Verstärkerstufen durchläuft, AD-gewandelt wird und anschließend das Wandlungsergebnis durch den Verstärkungsfaktor des Vorverstärkers geteilt wird. Die Präzision des Verstärkers hat einen direkten Einfluß auf das Wandlungsergebnis.

Im Wissen um diese Fehler sind bisher die Verstärker auf eine bestimmte Verstärkung hin und auf einen möglichst kleinen Offset hin abgeglichen worden. Der Abgleich für einen 20bit-AD-Wandler oder sogar einen AD-Wandler mit noch höherer Auflösung ist technisch schwierig. Außerdem ist jeder Abgleich dieser Art alterungs- und temperaturabhängig. Die Korrektur von Verstärkungs- und Offsetfehlern ist also durchaus fachüblich und ist bei hochauflösenden AD-Wandler (mit 20 oder mehr bit) problematisch.

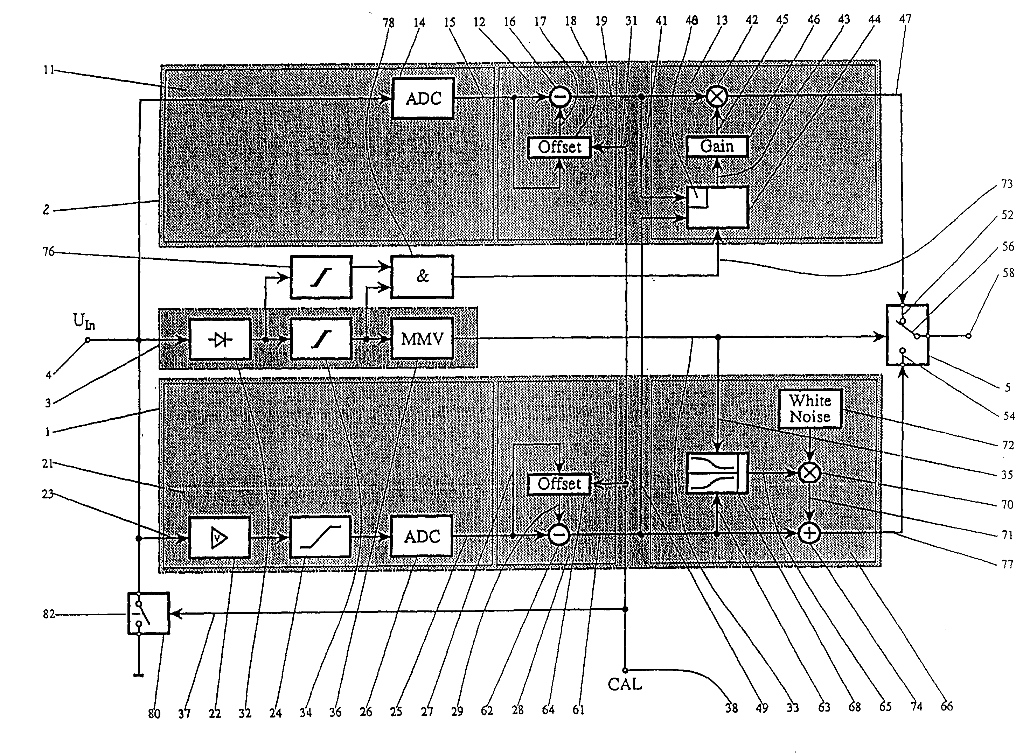

Die Erfindung wird nachstehend anhand des in der beigefügten Zeichnung dargestellten beispielhaften Schaltungsdiagramms im einzelnen beschrieben.

Gemäß dem in der Zeichnung dargestellten Ausführungsbeispiel der Erfindung besteht die Vorrichtung aus zwei Signalpfaden 1, 2 sowie einem Steuerpfad 3, die zwischen einer mit U_{In} beschrifteten Eingangsklemme 4 und einem Umschalter 5 parallel geschaltet sind.

Der erste Signalpfad 1 weist drei hintereinandergeschaltete Stufen auf, von denen die erste Stufe 21, in Reihe geschaltet, einen Verstärker 22 mit dem Verstärkungsgrad V, einen Spannungsbegrenzer 24 und einen A/D-Wandler 26 enthält. Die Eingangsleitung 23 des Verstärkers 22 ist mit dem Signaleingang 4 verbunden. Die Ausgangsleitung 25 aus dem A/D-Wandler 26 ist gleichzeitig Eingangssignalleitung für die zweite Stufe 28. Sie enthält einen mit der Signaleingangsleitung 25 verbundenen Subtrahierer 62, dessen weitere Eingangsleitung 29 aus einem Offsetregister 64 kommt. Über eine Zweigleitung 27 der Signalleitung 25 kann das Offset-Register 64 mit dem auf Signalleitung 25 stehenden Signal bei Vorliegen eines Steuersignals CAL auf Leitung 31 geladen werden.

Die Ausgangsleitung 61 des Subtrahierers 62 ist sowohl Signalausgangsleitung der zweiten Stufe 28 wie auch Signaleingangsleitung für die dritte Stufe 66 des ersten Signalpfads 1. Eine Zweigleitung 49 der Signalleitung 61 führt zu einer 1. Schaltung 44 in der dritten Stufe 13 des zweiten Signalpfads 2. Eine weitere Zweigleitung 63 von der Signalleitung 61 führt zu einem Eingang einer weiteren 2. Schaltung 68, dessen Ausgangsleitung 65 in einen Multiplizierer 70 führt. Der Multiplizierer 70 erhält einen weiteren Eingang aus einem Rauschgenerator 72. Der Ausgang des Multiplizierers 70 führt über Leitung 71 zu einem Eingang eines Addierers 74, der seinen anderen Eingang aus der Signalleitung 61 erhält. Die Ausgangsleitung 77 des Addierers führt zu einem Schaltkontakt 54 des Umschalters 5.

Der zweite Signalpfad 2 weist ebenfalls drei hintereinandergeschaltete Stufen 11, 12, 13 auf, von denen die erste Stufe 11 einen eingangsseitig mit der Klemme 4 verbundenen A/D-Wandler 14 besitzt. Ausgangsseitig ist der A/D-Wandler 14 mit dem Eingang der zweiten Stufe 12 über Leitung 15 verbunden. Die Eingangsleitung 15 der zweiten Stufe 12 führt einerseits zum Eingang eines Subtrahierers 16 und über eine Zweigleitung zum Ladeeingang eines Offset-Registers 18, welches bei Vorliegen eines CAL-Steuersignals auf Steuersignalleitung 31 am Steuereingang des Offset-Registers 18 von den auf Leitung 15 ankommenden Signalen geladen wird. Der Inhalt des Offsetregisters 18 gelangt über Leitung 17 in den Subtrahierer 16. Die Ausgangsleitung 19 des Subtrahierers 16 ist zugleich Ausgangsleitung der zweiten Stufe 12 und Eingangsleitung für die dritte Stufe 13.

Die dritte Stufe 13 weist einen Multiplizierer 42 auf, der die auf Signalleitung 19 ankommenden Signale empfängt. Eine Zweigleitung 41 von der Signalleitung 19 führt zu einem y-Eingang der 1. Schaltung 44, der über eine Ausgangsleitung 43 ein Verstärkungsfaktorregister 46 laden kann. Der im Verstärkungsfaktorregister 46 enthaltene digitale Wert wird über Ausgangsleitung 45 als weiterer Eingang dem Multiplizierer 42 zugeführt werden. Die Ausgangsleitung 47 des Multiplizierers 42 führt zu einem weiteren Schaltkontakt 52 des Umschalters 5.

Der Steuerpfad 3 enthält eine Reihenschaltung aus einem Gleichrichter 32, dessen Eingang am Signaleingang 4 liegt, eine 3. Schaltung 34 and einer Schaltung 36, deren Steuersignal-Ausgangsleitung 33 einerseits zu einem Steuereingang des Umschalters 5 sowie andererseits über Zweigleitung 35 zu einem weiteren Eingang der 1. Schaltung 68 führt. Ein Steuersignal auf Leitung 33 bewirkt das Umlegen des Schaltarms 56 des Umschalters 5 von Kontakt 52 auf Kontakt 54 oder umgekehrt. Vom Schaltarm 56 wird über Anschluß 58 der ausgewählte digitale Datenstrom zur Weiterverarbeitung bereitgestellt.

An der Klemme 38 liegt das extern gebildete Kalibriersignal als Steuersignal CAL an, welches über Signalleitung 31, wie erwähnt, den Offset-Registern 18 und 64 sowie über Steuersignalleitung 37 dem Steueranschluß eines Relais 80 zugeführt wird. Das Relais 80 kann in Abhängigkeit vom Vorliegen eines Steuersignals auf Leitung 37 den Signaleingangsanschluß 4 mit Masse kurzschließen.

Die beiden Stufen 12 und 28 sind, wie vorstehend erläutert, gleich aufgebaut und dienen dazu, in den Schaltkreisen der jeweils zugehörigen ersten Stufen 11 und 21 auftretende fehlerhafte Gleichspannungverschiebungen zu kompensieren. Dazu dient das Kalibriersignal CAL am Anschluß 38. Das Kalibrieren kann zu beliebigem Zeitpunkt durchgeführt werden. Es empfiehlt sich, die Kalibrierung vor der Audiosignalumwandlung sowie gegebenenfalls zu späteren geeigneten Zeitpunkten durchzuführen.

Da sich die Gleichspannungsverschiebung in der Regel nur sehr langsam ändert, genügt es, die Kalibrierung nur in größeren zeitlichen Abständen zu veranlassen.

Solange die Spannung U_{In} am Eingangskontakt des umzuwandelnden Audiosignals Null beträgt (etwa aufgrund eines Kurzschlusses durch Relais 80), werden den Subtrahierern 16 und 62 bei jedem Samplingimpuls aus den vorgeschalteten Wandlern und sonstigen Schaltkreisen Datenwörter zugeführt, die den Offsetfehler repräsentieren. Solange das Kalibriersignal CAL auf Leitungen 31 und 37 nicht ansteht, bleiben die Eingänge zu den Offset-Registern 18 und 64 gesperrt und der Kontakt 82 des Relais 80 geöffnet. Wenn dagegen das Kalibriersignal CAL über Kontakt 38 auf Leitungen 31 und 37 ansteht, wird das Relais 80 zunächst den Kontakt 82 schließen und U_{In} durch Kurzschluß des Kontaktes 4 mit Masse zu Null machen. Das CAL-Signal öffnet ferner die Eingänge in die Offset-Register 18 und 64, so daß diese beim nächsten Sampling-Impuls das den Offset-Fehler repräsentierende Datenwort aufnehmen und über Leitungen 17 und 29 veranlassen, daß dieses Datenwort von dem Eingangssignal aus den Wandlern 14 beziehungsweise 26 in den Subtrahierern 16 beziehungsweise 62 subtrahiert wird. In diesem Kalibriermodus treten daher auf den Ausgangsleitungen 19 und 61 Datenwörter mit dem Inhalt Null auf. Nach Beendigung des CAL-Signals behalten die Offset-Register 18 und 64 die während des Kalibrierens neu geladenen Werte.

Die am Kontakt 4 anliegende Spannung U_{In} des umzuwandelnden analogen Audiosignals, wird den drei Stufen 1, 2, 3 parallel zugeführt.

Der Signalpfad 1 dient der A/D-Wandlung von Audiosignalen U_{In} mit niedrigem Pegel. Deshalb ist im Signalpfad 1 ein Verstärker 22 enthalten. Der Signalpfad 2 dient der A/D-Wandlung von Audiosignalen U_{In} mit hohen Pegel und weist daher keinen Verstärker auf. Im Signalpfad 3, dem Steuersiqnalpfad, wird das Audiosignal U_{In} in der Stufe 34 mit einem Schwellwert verglichen. Das Vergleichsergebnis, das somit von der Amplitude des Audiosignals U_{In} abhängig ist, dient der Steuerung des Umschalters 5. Bei Erreichen des Schwellwertes in der Stufe 34 durch das Audiosignal U_{In} wird der Umschalter 5 zur Auswahl des Datenstromes veranlaßt, dessen erste Stufe 11 keinen Verstärker enthält. Beim Unterschreiten des Schwellwertes durch das Audiosignal U_{In}, gegebenfalls nach einer Zeitspanne, wird der Umschalter 5 zur Auswahl des Datenstromes aus dem Pfad veranlaßt, dessen erste Stufe 21 den Verstärker 22 enthält.

Da der A/D-Wandler 14 das Eingangssignal U_{In} (im Gegensatz zu dem A/D-Wandlern 26) unverstärkt erhält, läßt sein Wertevorrat eine Kodierung des Audioeingangssignals bei Pegeln, die bereits oberhalb der Aussteuerungsgrenze des A/D-Wandlers 26 und damit oberhalb des Schwellwertes liegen noch zu. Der Datenstrom aus dem A/D-Wandler 14 wird nach der Korrektur des Offsetfehlers in der Stufe 12 in dem nachgeschalteten Multiplizierer 42 mit dem in dem Verstärkungsfaktorregister 46 enthaltenen Verstärkungsfaktor um eine Verstärkung V verstärkt, die gleich der Verstärkung V des Verstärkers 22 ist.

Obwohl die Verstärkung beider Pfade (1,2) theroretisch gleich V ist, ergibt sich aufgrund der inhärenten Unterschiede in den Parametern und Toleranzen der beteiligten elektronischen Schaltkreise ein unerwünschter Verstärkungsunterschied.

Dazu wird in der 1. Schaltung 44 eine Mittelwertbildung über n Samplingimpulse mit dem Datenstrom xᵢ aus dem Signalpfad 1 mit Verstärkung vor der Umwandlung und den um den Faktor V verstärkten Datenstrom yᵢ aus dem Signalpfad 2 ohne Vorverstärkung durchgeführt. Mit dieser jeweils über n Samplingimpulse laufenden Mittelwertbildung wird der tatsächliche Unterschied der Verstärkungsgrade der digitalen Datenströme auf den Ausgangsleitungen 47 und 77 reduziert.

Die 1. Schaltung 44 führt zur Bestimmung des Faktors V eine Mittelwertbildung nur für Eingangssignale U_{In} durch, die im Pegelbereich des analogen Audiosignals U_{In} zwischen sw/2<U_{In}<sw liegen, wobei sw den Schwellwert repräsentiert.

Am Ausgang des Gleichrichters 32 ist eine 4. Schaltung 76 angeschlossen, die ein Ausgangssignal an ein und- Gatter 78 abgibt. Der andere Eingang des Gatters 78 ist das Ausgangssignal aus der 3. Schaltung 34. Das Ausgangssignal des UND-Gatters 78 wird als Aktivierungssignal der 1. Schaltung 44 über Leitung 73 zugeführt.

Das im zweiten Pfad 2 von den Stufen 11, 12 und 13 erzeugte Rauschen, das im Datenstrom auf Leitung 47 enthalten ist, fällt wegen der Verstärkung nach der A/D-Wandlung im Datenstrom auf Leitung 47 stärker ins Gewicht als der Rauschbeitrag im Datenstrom auf Leitung 77 aus dem ersten Pfad 1, weil dort die Verstärkung bereits in der ersten Stufe 21 erfolgt.

Daher wird ein vom Rauschgenerator 72 abgegebenes Rauschsignal über Multiplizierer 70 und Addierer 74 dem Datenstrom auf Leitung 77 zugeführt.

Somit wird der Rauschbeitragsunterschied zwischen den Pfaden 1 und 2 ausgeglichen.

## Patentansprüche

1. Schaltungsanordnung zur Umsetzung eines analogen Audiosignals in einen hochauflösenden Bitstrom, wobei ein Audiosignal (U_{In}) auf mehreren parallelen Pfaden (1, 2) mit unterschiedlicher Amplitudenempfindlichkeit in je einen Datenstrom umgesetzt wird, ***dadurch gekennzeichnet,* daß** anschließend die durch die unterschiedliche Amplitudenempfindlichkeit hervorgerufenen Fehler kompensiert werden und einer der Datenströme als Bitstrom zur Weiterbearbeitung bereit gestellt wird, wobei jeder der Pfade (1, 2) drei in Reihe geschaltete Stufen (21, 28, 66, 11, 12, 13) aufweist, in den beiden ersten Stufen (21, 11) die Umwandlung des Audiosignals in den Bitstrom erfolgt und in den jeweils nachgeschalteten Stufen (28, 66; 12, 13) die Fehlerkompensation durchgeführt wird, in jeder der zweiten Stufen (28,12) der Pfade (1, 2) jeweils die durch die jeweils vorgeschaltete Stufe (21, 11) erzeugte Gleichspannungsverschiebung kompensiert wird, in der dritten Stufe (13) desjenigen Pfades (2), in dessen erster Stufe (11) das Audiosignal nicht verstärkt wird, eine Verstärkungsfehlerreduzierung durchgeführt wird und wobei die Verstärkungsfehlerkorrektur durch Multiplikation mit dem Verstärkungsfaktor V in demjenigen Pfad erfolgt, dessen Analog-Digital-Wandler (14) das unverstärkte Signal wandelt, in dem der Verstärkungsfaktor V durch Mittelwertbildung über mehrere Samplingperioden aus den Datenströmen der jeweiligen zweiten Stufen (28, 12) berechnet wird.

2. Schaltungs-Anordnung nach Anspruch 1, ***dadurch gekennzeichnet,* daß** die Auswahl des Datenstroms, der als Bitstrom zur Weiterbearbeitung bereitgestellt wird, von der Amplitude des Audiosignals (U_{In}) abhängig ist.

3. Schaltungs-Anordnung nach einem der vorigen Ansprüche, ***dadurch gekennzeichnet,* daß** Gleichspannungskompensation in den zweiten Stufen (28, 12) durch ein Kalibriersignal (CAL) aktualisiert wird.

4. Schaltungs-Anordnung nach einem der vorigen Ansprüche, ***dadurch gekennzeichnet,* daß** in jeder der ersten Stufen (21, 11) je ein Analog/Digital-Wandler (26, 14) vorgesehen ist, wobei dem A/D-Wandler (26) einer der beiden Stufen eine Verstärker (22) vorgeschaltet ist.

5. Schaltungs-Anordnung nach Anspruch 3, ***dadurch gekennzeichnet,* daß** das Kalibriersignal (CAL) einen Eingangsanschluß (4) für die Audiosignale (U_{In}) kurzschließt und in jeder der beiden zweiten Stufen (28, 12) je ein Offset-Register (64, 18) zur Übernahme eines Datenwortes aus den vorgeschalteten ersten Stufen (21, 11) veranlaßt, wobei von dem Datenstrom in einem Subtrahierer (62, 16) der Inhalt des zugehörigen Offset-Registers (64, 18) subtrahiert wird.

6. Schaltungs-Anordnung nach einem der vorstehenden Ansprüche, ***dadurch gekennzeichnet,* daß** der Datenstrom in der dritten Stufe (13) desjenigen Pfades (2) in dessen erster Stufe (11) das Audiosignal nicht verstärkt wird, um den Verstärkungsfaktor des Verstärkers (22) verstärkt wird.

7. Schaltung-Anordnung nach einem der vorstehenden Ansprüche, ***dadurch gekennzeichnet,* daß** zwischen einem Eingangsanschluß (4) für die Audiosignale (U_{In}) und einem Umschalter (5) die beiden Pfade (1, 2) sowie ein Steuersignalpfad (3) parallelgeschaltet sind, wobei in dem Steuersignalpfad (3) aus dem Pegel des Audiosignals ein Steuersignal zum Umschalten des Umschalters (5) gebildet wird.

8. Schaltungs-Anordnung nach Anspruch 7, ***dadurch gekennzeichnet,* daß** der Pegel des Analogsignals (U_{In}) in dem Steuersignalpfad (3) mit einem Schwellwert (in 34) verglichen wird und aus dem Vergleichsergebnis Steuersignale für den Umschalter(5) gebildet werden, derart, daß bei Erreichen des Schwellwertes durch den Pegel der Umschalter (5) zur Auswahl des Datenstroms aus demjenigen Pfad (2) veranlaßt wird, dessen erste Stufe keinen Verstärker enthält, und bei Unterschreiten des Schwellwertes durch den Pegel, gegebenenfalls nach einer vorgegebenen Zeitspanne, der Umschalter (5) zur Auswahl des Datenstroms aud dem Pfad, dessen ersten Stufe (21) den Verstärker (22) enthält, veranlaßt wird.

9. Schaltungs-Anordnung nach Anspruch 1, ***dadurch gekennzeichnet,* daß** die Verstärkungsfehlerkorrektur in einem Pegelbereich durchgeführt wird, der etwa zwischen dem halben Schwellwert und dem Schwellwert liegt.

10. Schaltungs-Anordnung nach Anspruch 1, ***dadurch gekennzeichnet,* daß** die Mittelwertbildung über n Samplingimpulse mit dem Datenstrom xᵢ aus dem Pfad (1) mit Verstärkung vor der Umwandlung und den um V verstärkten Datenstrom yᵢ aus dem Pfad (2) ohne Vorverstärkung erfolgt.

11. Schaltungs-Anordnung nach einem der vorstehenden Ansprüche, ***dadurch gekennzeichnet,* daß** in der dritten Stufe (66) des Pfades (1) mit Vorverstärkung eine Rauschpegelanpassung durchgeführt wird.

12. Schaltungs-Anordnung nach Anspruch 11, ***dadurch gekennzeichnet,* daß** die Rauschpegeladdition in der dritten Stufe (66) mit bis zum Schwellwert zunehmendem Pegel des Audiosignals (U_{In}) bis zum Rauschanteil des Datenstroms aus der dritten Stufe des anderen Pfades (2) angehoben wird.

13. Schaltungs-Anordnung nach Anspruch 11 oder 12, ***dadurch gekennzeichnet,* daß** die Ausgangssignale eines Rauschgenerators (72) mit Werten in einen Multiplizierer (70) vor der Zumischung zu dem Datenstrom multipliziert werden, welche von dem Datenstrom aufgerufen werden.

14. Schaltungs-Anordnung nach einem der Ansprüche 11 bis 13, ***dadurch gekennzeichnet,* daß** in der dritten Stufe (66) ein weiterer Wertebereich gespeichert ist, der im Samplingtakt nach Art einer Rampe absteigende, von einem Steuersignal aus dem Steuersignalpfad (3) abgerufene Werte aufweist, die nach Multiplikation mit den aus dem Rauschgenerator (72) kommenden Rauschsignalen dem Datenstrom zugemischt werden.

15. Schaltungs-Anordnung nach Anspruch 14, ***dadurch gekennzeichnet,* daß** die Rauschsignale aus dem Rauschgenerator (72) in dem Multiplizierer (70) mit demjenigen Wert aus den beiden Wertebereichen multipliziert wird, der der größere ist.

## Claims

1. A circuit layout for the conversion of an analog audio signal into a high-resolution bit stream, with an audio signal (U_{In}), in multiple parallel paths (1, 2) with varying amplitude sensitivity, converted into one datastream for each of the paths, ***characterized in that,*** subsequently, the errors produced by the varying amplitude sensitivity are compensated and one of the datastreams is made available for further processing as a bit stream, with each of the paths (1, 2) having three stages (21, 28, 66, 11, 12, 13) connected in series, the conversion of the audio signal into the bit stream occurring in the first two stages (21, 11) and the error compensation being performed in each of the downstream stages (28, 66; 12, 13), the DC offset produced in the respective upstream stages (21, 11) being compensated in each of the respective second stages (28, 12) of the paths (1, 2), an amplification error reduction being performed in the third stage (13) of that path (2) in whose first stage (11) the audio signal was not amplified, and with the amplification error correction being performed, through multiplication with the amplification factor V, **in that** path whose analog digital converter (14) converts the unamplified signal, **in that** the amplification factor V is calculated, through averaging over multiple sampling periods, from the datastreams of the respective second stages (28, 12).

2. The circuit layout according to claim 1, ***characterized in that*** the selection of the datastream which is made available as a bit stream for further processing is dependent on the amplitude of the audio signal (U_{In}).

3. The circuit layout according to one of the preceding claims, ***characterized in that*** direct current compensation is actualized in the second stage (28, 12) by a calibration signal (CAL).

4. The circuit layout according to one of the preceding claims, ***characterized in that*** an analog/digital converter (26, 14) is provided in each of the first stages (21, 11), with an amplifier (22) connected upstream from the A/D converter (26) of one of the two stages.

5. The circuit layout according to claim 3, ***characterized in that*** the calibration signal (CAL) short-circuits an input terminal (4) for the audio signals (U_{In}) and causes an offset register (64, 18) in each of the two second stages (28, 12) to transfer a data word from each of the upstream first stages (21, 11), with the content of the associated offset register (64, 18) being subtracted from the datastream in a subtracter (62, 16).

6. The circuit layout according to one of the preceding claims, ***characterized in that*** the datastream is amplified, by the amplification factor of the amplifier (22), in the third stage (13) of that path (2) in whose first stage (11) the audio signal was not amplified.

7. The circuit layout according to one of the preceding claims, ***characterized in that*** the two paths (1, 2) and a control signal path (3) are connected in parallel between an input terminal (4) for the audio signal (U_{In}) and a transfer switch (5), with a control signal for switching the transfer switch (5) being formed from the level of the audio signal in the control signal path (3).

8. The circuit layout according to claim 7, ***characterized in that*** the level of the analog signal (U_{In}) is compared in the control signal path (3) with a threshold value (in 34) and control signals for the transfer switch (5) are formed from the result of the comparison in such a way that, upon the level reaching the threshold value, the transfer switch (5) is caused to select the datastream from that path (2) whose first stage does not contain an amplifier, and, if the level falls below the threshold value, if necessary after a predetermined period of time, the transfer switch (5) is caused to select the datastream from that path whose first stage (21) does contain the amplifier (22).

9. The circuit layout according to claim 1, ***characterized in that*** the amplification error correction is performed within a level range which lies between approximately half of the threshold value and the threshold value.

10. The circuit layout according to claim 1, ***characterized in that*** the averaging is performed over n sampling pulses, with the datastream xᵢ from the path (1) having amplification before the conversion and the datastream yᵢ, from the path (2) not having preamplification, amplified by V.

11. The circuit layout according to one of the preceding claims, ***characterized in that*** a noise level adjustment is performed in the third stage (66) of the path (1) with preamplification.

12. The circuit layout according to claim 11, ***characterized in that*** the noise level addition in the third stage (66) is boosted, with the level of the audio signal (U_{In}) increasing up to the threshold level, up to the noise portion of the datastream from the third stage of the other path (2).

13. The circuit layout according to claim 11 or 12, ***characterized in that*** the output signal of a noise generator (72) is multiplied in a multiplier (70), before admixture into the datastream, with values called from the datastream.

14. The circuit layout according to one of the claims 11 to 13, ***characterized in that*** a further value range is stored in the third stage (66), having values called by a control signal from the control signal path (3), which increase in the sampling clock like a ramp, which are admixed into the datastream after multiplication with the noise signals coming from the noise generator (72).

15. The circuit layout according to claim 14, ***characterized in that*** the noise signals from the noise generator (72) are multiplied in the multiplier (70) with the value from the two value ranges which is larger.

## Revendications

1. Ensemble de circuits pour la conversion d'un signal audio analogique en un flux de bits à haute définition, un signal audio (Utn) étant converti sur plusieurs pistes parallèles (1, 2) en un flux de données correspondant, avec une sensibilité d'amplitude variable, **caractérisé en ce qu'**ensuite, les erreurs provoquées par cette sensibilité d'amplitude variable sont compensées et qu'un des flux de données est mis à disposition sous forme de flux de bits pour la poursuite du traitement, chacune des pistes (1, 2) présentant trois degrés (21, 28, 66, 11, 12, 13) connectés dans l'ordre, la conversion du signal audio en flux de bits ayant lieu dans les deux premiers degrés (21, 11), la compensation des erreurs ayant lieu dans les degrés connectés corrélativement (28, 66 ; 12, 13), le décalage de tension constante consécutif étant compensé dans chacun des deux degrés (28, 12) des pistes (1, 2) une réduction des erreurs de d'amplification ayant respectivement lieu au degré connecté préalablement (21, 11), au troisième degré (13) de la piste (2) au premier degré (11) de laquelle le signal audio n'est pas amplifié, une correction des erreurs d'amplification étant réalisée et cette correction ayant lieu par multiplication avec le facteur d'amplification V dans la piste dont le convertisseur analogique-numérique (14) convertit le signal non amplifié, dans lequel le facteur d'amplification V est calculé par élaboration de valeurs moyennes sur plusieurs périodes d'échantillonnage des flux de données des deuxièmes degrés (28, 12) correspondants.

2. Ensemble de circuits selon la revendication 1, ***caractérisé en ce que*** le choix du flux de données qui est mis à disposition sous forme de flux en bits pour la poursuite du traitement dépend de l'amplitude du signal audio (Utm).

3. Ensemble de circuits selon une des revendications précédentes, **caractérisé en ce que** la compensation de tension constante est actualisée dans les deuxièmes degrés (28, 12) par un signal de calibrage (CAL).

4. Ensemble de circuits selon une des revendications précédentes, ***caractérisé en ce que**,* dans chacun des premiers degrés (21, 11), un convertisseur analogique-numérique (26, 14) est prévu, un amplificateur (22) étant préalablement connecté au convertisseur A/D (26) d'un des deux degrés.

5. Ensemble de circuits selon la revendication 3, ***caractérisé en ce que*** le signal de calibrage (CAL) court-circuite un raccordement d'entrée (4) pour les signaux audio (Utn) et provoque respectivement un enregistrement offset (64, 18) dans chacun des deux premiers degrés (28, 12) pour la récupération d'un terme de données dans les deux premiers degrés (21, 11) préalablement branchés, le contenu de l'enregistrement offset correspondant (64, 18) étant soustrait du flux de données dans un soustracteur (62, 16).

6. Ensemble de circuits selon une des revendications précédentes, ***caractérisé en ce que*** le flux de données, au troisième degré (13) de sa piste (2), au premier degré de laquelle (11) le signal audio n'est pas amplifié, est amplifié du facteur d'amplification de l'amplificateur (22).

7. Ensemble de circuits selon une des revendications précédentes, ***caractérisé en ce* qu'**entre le raccordement d'entrée (4) pour les signaux audio (Utm) et un commutateur (5), les deux pistes (1, 2) ainsi qu'une piste de signaux de commande (3) sont connectées parallèlement, un signal de commande pour la commutation du commutateur (5) étant généré dans la piste de signaux de commande (3) à partir de l'échelle du signal audio.

8. Ensemble de circuits selon la revendication 7, ***caractérisé en ce que*** le niveau du signal analogique (Utm) est comparé dans la piste de signaux de commande (3) à une valeur variable (en 34) et que des signaux de commande pour le commutateur (5) sont générés à partir du résultat de la comparaison, de manière que, lorsque la valeur limite est atteinte, le commutateur (5) est sollicité à partir de l'échelle pour le choix du flux de données dans la piste (2) dont le premier degré ne contient pas l'amplificateur et que, lors du dépassement de la valeur variable par le niveau, éventuellement après un laps de temps déterminé, le commutateur (5) est sollicité pour le choix du flux de données dans la piste dont le premier degré (21) contient l'amplificateur (22).

9. Ensemble de circuits selon la revendication 1, ***caractérisé en ce que*** la correction des erreurs d'amplification est réalisée dans une fourchette de l'échelle se situant à peu près entre la moitié de la valeur limite et la valeur limite.

10. Ensemble de circuits selon la revendication 1, ***caractérisé en ce que*** l'élaboration d'une valeur moyenne a lieu sur n impulsions d'échantillonnage avec le flux de données xi de la piste (1), avec amplification avant la conversion et le flux de données yi, amplifié de V, de la piste (2) sans amplification préalable.

11. Ensemble de circuits selon une des revendications précédentes, ***caractérisé en ce qu***'une adaptation de l'échelle sonore est réalisée dans le troisième degré (66) de la piste (1) avec amplification préalable .

12. Ensemble de circuits selon la revendication 1, ***caractérisé en ce que*** l'addition de l'échelle sonore dans le troisième degré (66) est augmentée jusqu'au niveau croissant jusqu'à la valeur limite du signal audio (Utm) jusqu'au taux sonore du flux de données du troisième degré de l'autre piste (2).

13. Ensemble de circuits selon la revendication 11 ou 12, ***caractérisé en ce que*** les signaux de sortie d'un générateur sonore (72) sont multipliés avec des valeurs dans un multiplicateur (70) avant d'être mêlés au flux de données, ces valeurs étant prélevées dans le flux de données.

14. Ensemble de circuits selon une des revendications 11 à 13, ***caractérisé en ce que**,* dans le troisième degré (66), une fourchette supplémentaire de valeurs est mémorisée, qui comporte des valeurs décroissant en forme de rampe dans le cycle d'échantillonnage et prélevées par une commande de signaux dans la piste de signaux de commande (3), qui sont mêlées au flux de données après multiplication avec les signaux sonores provenant du générateur sonore (72).

15. Ensemble de circuits selon la revendication 14, ***caractérisé en ce que*** les signaux sonores provenant du générateur sonore (72) sont multipliés dans le multiplicateur (70) avec la valeur la plus élevée des deux fourchettes de valeurs.
